# EUROPÄISCHE PATENTSCHRIFT

(11) **EP 0 307 574 B1**
(45) Veröffentlichungstag und Bekanntmachung des Hinweises auf die Patenterteilung: **23.06.1993**
(21) Anmeldenummer: 88111241.1
(22) Anmeldetag: 13.07.1988
(51) Int. Cl.: H05K 13/04, B23K 1/00

(54) **Lötkopf zum Ein- und Auslöten von Bauelementen**
Soldering head for soldering or unsoldering components
Tête de brasage pour le brasage et le débrasage de composants

(30) Priorität: 31.08.1987 DE 3729042
(43) Veröffentlichungstag der Anmeldung: 22.03.1989
(73) Patentinhaber: SIEMENS AKTIENGESELLSCHAFT, 80333 München (DE)
(72) Erfinder: Bunz, Georg, D-8000 München 70 (DE)

(56) Entgegenhaltungen:
- EP-A- 0 040 669
- CH-A- 321 976
- US-A- 3 912 153
- US-A- 4 295 596
- IBM TECHNICAL DISCLOSURE BULLETIN, Band 26, Nr. 9. Februar 1984, Seiten 4780-4782, New York, US; A.R. FORMICHELLI et al.: "Non-destructive torsional chip removal"

## Beschreibung

Die Erfindung betrifft einen Lötkopf zum Ein- oder Auslöten von Bauelementen, insbesondere für oberflächenmontierbare Bauelemente (SMD) mit einem annähernd vertikal zu Leiterplatte und Bauelement stehenden Sichtschacht. Die Erfindung betrifft außerden eine Anordnung solcher Lötköpfe.

Bei der Fertigung von elektronischen Flachbaugruppen ist in der letzten Zeit ein Übergang von der herkömmlichen Technik der Einsteckmontage zur Technik der Oberflächenmontage von flach auflötbaren Bauelementen zu verzeichnen. Die hierbei eingesetzten oberflächenmontierbaren Bauelemente (SMD ≙ Surface Mounted Devices) werden durch Bestückautomaten auf den Leiterplatten positioniert, meistens mittels mehrerer Klebstoffpunkte fixiert und anschließend durch ein übliches Lötverfahren verlötet, womit die elektrische Verbindung hergestellt ist. Die bei derartigen Verfahren auftretenden Fehler, sei es durch Einbau falscher oder defekter Bauelemente oder zum Beispiel durch falsche Positionierung, müssen in einem seperaten Verfahren durch Auslöten der entsprechenden Bauelemente und entsprechender Korrektur durch fehlerfreies Einlöten von neuen Bauelementen beseitigt werden. Dies geschieht mittels Vorrichtungen, die man im allgemeinen als Ein- und Auslötmaschinen bezeichnet. Derartige auf dem Markt erhältiche Maschinen müssen einer Vielzahl von Qualitätsanforderungen genügen. So ist es erforderlich, daß der Platz eines defekten Bauelementes, welches ausgelötet und durch fehlerfreies Einlöten eines funktionsfähigen Bauelementes ersetzt werden soll, ohne Behinderungen und ohne Parallaxen-Fehler zu betrachten ist. Des weiteren muß die Heizeinrichtung, mit der die Anschlußbeine des Bauelementes zum Aus- oder Einlöten beheizt werden, eine gleichmäßige Temperaturverteilung über die verschiedenen Anschlußbeine aufweisen und darf zugleich den Körper des Bauelementes nicht zu sehr erhitzen. Ebenso werden hohe Anforderungen an die Ausrichtung des Bauelementes bezüglich der Leiterplatte und des Lötplatzes, an die exakte Dosierung von Lotpaste, an die Kühlung des Bauelementes nach dem Einlöten, sowie an die Handhabung eines durch den Bestückautomaten aufgeklebten Bauelementes beim Auslöten in der Ein- oder Auslötmaschine gestellt.

Die auf dem Markt erhältlichen Geräte weisen in keiner Weise eine parallaxenfreie Beobachtungseinrichtung auf, mit der der Ein-oder Auslötplatz auf der Leiterplatte beobachtet werden kann.

In der US-A-3 912 153 wird ein Lötkopf beschrieben der aus Edelstahl sein kann und mit dem elektronische Bauelemente auf Leiterplatten gelötet werden können. Es ist ein vertikaler Sichtschacht vorhanden, über den zumindest zeitweise das Bauelement betrachtet wird. Ein Teil dieses Sichtschachtes kann zeitweise auch als Heißgasschacht benutzt werden.

Die Druckschrift CH-A-321 976 offenbart einen schrägstehenden Drehteller mit verschiedenen Werkzeugen die nach Bedarf in Arbeitsstellung gebracht werden können (Revolverkopf-Anordnung).

Der Erfindung liegt die Aufgabe zugrunde, einen Lötkopf und eine Anordnung von Lötköpfen zum Ein- oder Auslöten von Bauelementen bereitzustellen, die Parallaxen-Fehler beim Ein- oder Auslöten von Bauelementen auf einer Leiterplatte vermeiden.

Die Lösung dieser Aufgabe wird durch die kennzeichnenden Teile der Ansprüche 1 und 9 beschrieben.

Da bei den verwendeten Ein- oder Auslötmaschinen in der Regel Miskroskope verwendet werden, um den Ein- oder Auslötvorgang zu betrachten, ist es ganz wesentlich, daß eine Betrachtung senkrecht von oben ermöglicht wird, da jede andere Vorgehensweise, wie z.B. Betrachtung in einem spitzen Winkel von der Seite, mit einem Parallaxen-Fehler verbunden ist. Bei der Dimension der Bauteile und vor allem der der Anschlußbeine, zu denen Betrachtung schon ein Mikroskop eingesetzt werden muß, ist dies von wesentlicher Bedeutung.

Die konstruktive Verwirklichung sieht vor, daß ein Bauelement auf einer Leiterplatte senkrecht von oben durch den Ein- oder Auslötkopf hindurch betrachtet werden kann. Dazu besitzt oder Lötkopf entsprechende Aussparungen, die einem Sichtschacht gleichkommen, und mindestens ein Sichtfenster um die zum Ein- oder Auslöten am Lötkopf bereitgestellte Wärme gezielt auf das Bauteil führen zu können und gleichzeitig die Betrachtung des Bauteiles zu ermöglichen.

Weitere vorteilhafte Ausgestaltungen der Erfindung sind den Ansprüchen 2 bis 8 zu entnehmen.

Besondere hieraus resultierende Vorteile sind zum einen, daß sich die oben beschriebene Gestaltung des Lötkopfes gut mit einer Beheizung durch Heißgas kombinieren läßt. Das von einem Pheripheriegerät bereitgestellte Heißgas wird meist seitlich in den Lötkopf eingeführt und durch den Lötkopf auf das Bauelement bzw. auf dessen Anschlußbeine geleitet. Um wesentliche Temperaturverluste zu vermeiden, sind derartige Lötköpfe im wesentlichen aus Edelstahl gefertigt, da dieser Werkstoff im Verhältnis zu alternativen Werkstoffen, wie z.B. Aluminium, eine relativ geringe Wärmeleitfähigkeit aufweist.

Zum anderen können die Innenflächen eines Sichtschachtes bei der Verwendung von Edelstahl durch Sandstrahlen gut entspiegelt werden, so daß bei der Betrachtung der Lötung keinerlei Fehler durch Spiegelungen möglich sind.

Der Einsatz von Edelstahl verhindert weiterhin eine Oxidation durch Lötmitteldämpfe, da übliches Lotmaterial sich nicht mit Edelstahl bindet.

Die Werkstoffauswahl bezüglich der hitzebeständigen transparenten Sichtfenster hat ergeben, daß am besten Quarzglas verwendet wird, welches mit Silikon gegenüber dem Edelstahl eingedichtet ist.

Zur einfachen Handhabung beim Aus- oder Einlöten von mehreren Bauelementen, die sich in ihrer Form und Größe auch unterscheiden können, ist eine Ausgestaltung der Erfindung der Einsatz eines schrägstehenden Drehtellers, der mehrere Lötköpfe aufnehmen kann und jeweils einen davon in dessen Arbeitsstellung arretiert. Dieser Lötkopf steht annähernd senkrecht, wobei das Bauelement unterhalb des Lötkopfes senkrecht von oben durch eine Optik durch den Lötkopf hindurch betrachtet werden kann.

Zur exakten Positionierung des Lötkopfes bezüglich des Bauelementes oder der Leiterplatte ist der Lötkopf in den drei Koordianten Richtungen frei bewegbar. Dies geschieht in der Regel durch einen x/y-Tisch, der Bauelement und Leiterplatte in x-und in y-Richtung bewegt und durch eine Hubeinrichtung, die auf den Lötkopf bezüglich der Höhenverstellung wirkt.

Im folgenden wird anhand von schematischen Figuren ein Ausführungsbeispiel beschrieben.
- Fig. 1: zeigt eine Ein- oder Auslötmaschine für SMD-Bauelemente 13 auf einer Leiterplatte 3.
- Fig. 2: zeigt einen Lötkopf 1 in einer detaillierteren Darstellung.
- Fig. 3: zeigt einen Lötkopf 1 mit Sichtschacht, Fenster 22 und zwei Zentrierbackenpaaren 23.

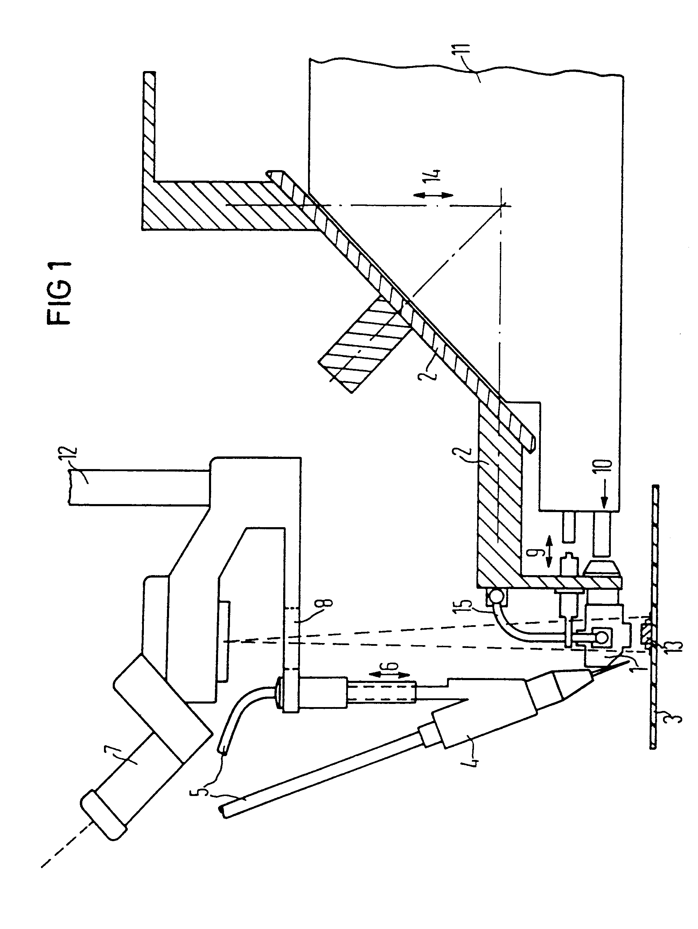

In der Fig. 1 ist schematisch eine Ein- oder Auslötmaschine dargestellt. Sie enthält folgende wesentlichen Teile:
- den Lötkopf 1
- den Drehteller 2
- die Leiterplatte 3
- ein SMD-Bauelement 13
- eine Dosiervorrichtung 4 für Lotpaste mit
- Druckluftanschluß 5 und
- Hubzylinder 6, sowie
- Sichtfenster 8
- eine Optik 7, hier ein Mikroskop
- ein Stativ 12 für die Optik 7 und Dosiervorrichtung 4
- ein Stativ 11 für den Drehteller 2 mit
- einer Hubeinrichtung 14
- eine Vakuumleitung 15
- einen Hubzylinder 9
- eine Heißgaszuführung 10.

Der am Drehteller 2 über einen Auslegearm befestigte Lötkopf 1 ist in seiner Arbeitsstellung derart positioniert und arretiert, daß mittels der Optik 7 das SMD-Bauelement 13 von oben durch das Sichtfenster 8 und durch den Lötkopf hindurch betrachtet werden kann. Durch Drehen des Drehtellers 2 können verschiedene an ihm über Auslegearme befestigte Lötköpfe bereit gestellt und in Arbeitsposition geschwenkt werden. Dargestellt ist lediglich ein zweiter Auslegearm, der jedoch nicht mit einem Lötkopf 1 versehen ist. Zum Ein- oder Auslöten wird über die Heißgaszuführung 10 dem Lötkopf 1 ein Heißgas zugeführt, daß im Lötkopf 1 auf die Anschlußbeine des SMD-Bauteils 13 geleitet wird und diese, sowie deren entsprechende Anschlußflecken auf die nötige Löttemperatur von beispielsweise 210° oder 225° C erhitzt. Über den Hubzylinder 9 werden die im Lötkopf 1 enthaltenen Zentrierbacken betätigt, die das SMD-Bauelement 13 zeitweise zentrieren und festhalten. Eine weitere Halterung des SMD-Bauelementes 13 am Lötkopf 1 ist durch eine Vakuumeinrichtung gegeben, die über eine Vakuumleitung 15 versorgt wird. Die exakte Positionierung des Lötkopfes 1 relativ zu dem SMD-Bauelement 13 geschieht zum einen durch die in x/y-Richtung mögliche Verschiebung der Leiterplatte 3, sowie über die Hubeinrichtung 14, die den Lötkopf bezüglich der Höhe einstellt. Die Dosiervorrichtung 4 wird über die Druckluftanschlüsse 5 versorgt und durch den Hubzylinder 6 zum Aufbringen einer genau dosierten Menge von Lotpaste auf die Leiterplatte senkrecht nach oben oder nach unten bewegt. Auch hier ermöglicht die Optik 7 zusammen mit der senkrechten Betrachtungsweise durch den Lötkopf 1 hindurch eine parallaxenfreie Betrachung des Ein- oder Auslötplatzes. Hierzu sind durch die Optik 7 in der Regel nur die Anschlußbeine des SMD-Bauteiles 13 sichtbar. Der zentral sitzende Körper des SMD-Bauteiles 13 ist durch die Vakuumeinrichtung verdeckt, die das Bauteil zeitweise hält.

Eine derartige Ein- oder Auslötmaschine für SMD-Bauteile 13 ist durch den Einsatz von Computerprogrammen automatisierbar. Hierzu sind drei wesentliche Arbeitsschritte zu benennen - das Auslöten, das Dosieren der Lotpaste, das Einlöten eines neuen SMD-Bauteiles.

Der Ablauf ist wie folgt:

### Auslöten

Über eine Grobjustierung wird der Lötkopf 1 ca. 20 mm über das SMD-Bauteil 13 gefahren und anschließend über eine Feinjustierung auf ca. 1 bis 2 mm angenähert und in x/y-Richtung ausgerichtet, so daß er direkt über dem Bauteil steht. Mittels des über den Lötkopf geführten Heißgases 10 werden die Anschlußbeine des SMD-Bauelementes 13 von Raumtemperatur mit einer Geschwindigkeit von etwa 1,5° C pro Sekunde bis auf ca. 200° C aufgeheizt. Anschließend wird der Lötkopf 1 auf das Bauelement 13 abgesetzt und das Vakuum eingeschaltet, wodurch das Bauelement am Lötkopf angesaugt und gehalten wird. Während des nun einsetzenden eigentlichen Auslötprozesses wird innerhalb von 5 bis 15 Sekunden die Temperatur von 200 bis 210° C oder beispielsweise 225° C erhöht und das Lot zum Fließen gebracht. Der Lötkopf hebt anschließend mit dem Bauelement ab. Die angegebenen Zahlenwerte beziehen sich auf den Einsatz einer üblichen Lotpaste.

### Dosieren

Bei in Arbeitsposition eingeschwenktem oder auch ausgeschwenktem Lötkopf 1 wird über die Dosiervorrichtung 4 eine exakt dosierte Menge Lotpaste auf die Anschlußflecken auf der Leiterplatte 3 aufgebracht. Dazu wird die Dosiervorrichtung 4 bis auf einen Abstand von ca. 1 bis 2 mm zur Leiterplatte 3 abgesenkt. Der Hubzylinder 6 sorgt für das Absenken einer Dosiernadel der Dosiervorrichtung 4. Die Menge der notwendigen Lotpaste kann über den Druck in der Druckluftzuführung 5, über die Zeit oder über den Durchmesser der Dosiernadel gesteuert werden.

### Einlöten

Das Einlöten geschieht in entsprechender Weise wie das Auslöten. Das SMD-Bauelement 13 wird von dem Lötkopf 1 aufgenommen, mittels Zentrierbacken zentriert und über ein Vakuum festgehalten. Die Zentrierbacken sind in diesem Zustand wieder gelöst. Nach einer Grobpositionierung erfolgt das Absenken auf die Leiterplatte und die Feinjustierung, wobei mit der Opitk 7 kontrolliert wird. Innerhalb der ersten Phase des Aufheizens wird wiederum mit einer Geschwindigkeit von ca. 1,5° C pro Sekunde bis auf ca. 200° C vorgeheizt und beispielsweise beim Einsatz einer handelsüblichen Lotpaste innerhalb von weiteren 5 bis 15 Sekunden auf ca. 225° C erhitzt. Die Halterung durch Ansaugen mittels Vakuum wird anschließend abgeschaltet, wobei gleichzeitig, um eine Nacherhitzung des Körpers der SMD-Bauteile 13 zu vermeiden, etwa 10 Sekunden lang kalte Luft direkt über die Vakuumleitung auf das SMD-Bauelement geblasen wird. Der Lötkopf 1 hebt nun ab und der Einlötvorgang ist beendet.

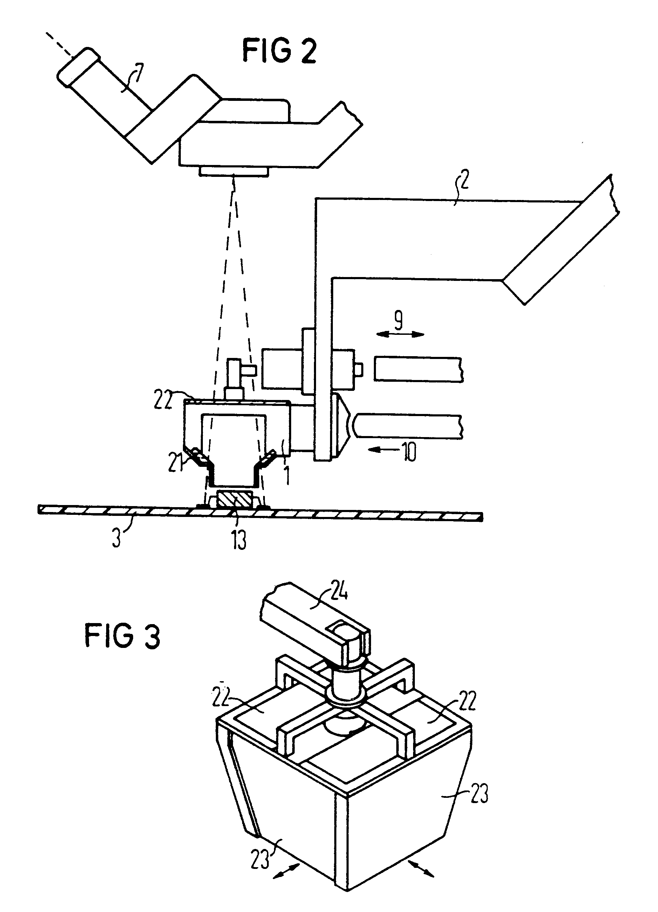

In der Fig. 2 ist in einer detallierteren Darstellung der Lötkopf 1 mit eingebauten Sichtfenstern 21 erkennbar, wobei das SMD-Bauteil 13, welches sich auf der Leiterplatte 3 befindet über die Optik 7 senkrecht von oben zu betrachten ist. Der Drehteller 2, die Heißgaszuführung 10 und der Hubzylinder 9 für die Betätigung der Zentrierbacken sind ebenfalls zu erkennen.

Die Fig. 3 zeigt eine Ausführung eines Lötkopfes mit einer Halterung 24, einem Sichtfenster 22 und mit zwei senkrecht zueinander stehenden Zentrierbackenpaaren 23, deren durch den Hubzylinder 9 erzeugbare Bewegungen zum Zentrieren und Greifen von SMD-Bauelementen 13 durch Pfeile angedeutet sind.

## Patentansprüche

1. Lötkopf (1) zum Ein- und Auslöten von Bauelementen (13), insbesondere fur oberflächenmontierbare Bauelemente (SMD) mit einem annähernd vertikal zu Leiterplatte (3) und Bauelement (13) stehenden Sichtschacht,
**dadurch gekennzeichnet,**
daß der Sichtschacht mindestens ein aus einem transparenten Material bestehendes Sichtfenster (21; 22) zur Betrachtung der Lötung aufweist.

2. Lötkopf (1) nach Anspruch 1,
**dadurch gekennzeichnet,**
daß der Sichtschacht zugleich ein Heißgasschacht ist.

3. Lötkopf (1) nach einem der vorhergehenden Ansprüche,
**dadurch gekennzeichnet,**
daß das Material des Lötkopfes (1) im wesentlichen Edelstahl ist.

4. Lötkopf (1) nach einem der vorhergehenden Ansprüche,
**dadurch gekennzeichnet,**
daß die Innenflächen eines Sichtschachtes entspiegelt sind.

5. Lötkopf (1) nach einem der vorhergehenden Ansprüche,
**dadurch gekennzeichnet,**
daß das Sichtfenster (21;22) aus hitzebeständigem transparentem Material besteht.

6. Lötkopf (1) nach Anspruch 5,
**dadurch gekennzeichnet,**
daß das hitzebeständige Material Quarzglas ist.

7. Lötkopf (1) nach Anspruch 5 oder 6,
**dadurch gekennzeichnet,**
daß das Sichtfenster mit Silikon eingedichtet ist.

8. Lötkopf (1) nach einem der vorhergehenden Ansprüche
**dadurch gekennzeichnet,**
daß der Lötkopf (1) relativ zur Leiterplatte (3) und Bauelement (13) in den drei Koordinatenrichtungen frei bewegbar ist.

9. Anordnung von Lötköpfen (1) entsprechend einem der Ansprüche 1 bis 8,
**dadurch gekennzeichnet,**
daß mehrere Lötköpfe (1) auf einem schrägstehenden Drehteller (2) derart montiert sind, daß jeweils einer davon in seiner Arbeitsstellung senkrecht steht und arretierbar ist.

## Claims

1. Soldering head (1) for soldering and unsoldering components (13), in particular for surface-mounting devices (SMD) having a viewing shaft which is approximately vertical with respect to the circuit board (3) and component (13), characterised in that the viewing shaft has at least one viewing window (21; 22), consisting of a transparent material, for viewing the soldering.

2. Soldering head (1) according to Claim 1, characterised in that the viewing shaft is at the same time a heating-gas shaft.

3. Soldering head (1) according to one of the preceding claims, characterised in that the material of the soldering head (1) is substantially high-grade steel.

4. Soldering head (1) according to one of the preceding claims, characterised in that the inner surfaces of a viewing shaft are antireflection-coated.

5. Soldering head (1) according to one of the preceding claims, characterised in that the viewing window (21; 22) consists of heat-resistant transparent material.

6. Soldering head (1) according to Claim 5, characterised in that the heat-resistant material is quartz glass.

7. Soldering head (1) according to Claim 5 or 6, characterised in that the viewing window is sealed in with silicone.

8. Soldering head (1) according to one of the preceding claims, characterised in that the soldering head (1) is freely movable in relation to the circuit board (3) and component (13) in the three coordinate directions.

9. Arrangement of soldering heads (1) corresponding to one of Claims 1 to 8, characterised in that a plurality of soldering heads (1) are mounted on a slanted turntable (2) in such a way that one of them in each case is perpendicular and lockable in its working position.

## Revendications

1. Tête de brasage (1) pour le soudage et le dessoudage de composants (13), notamment pour des composants montés en surface (SMD), comportant une colonne d'observation disposée approximativement perpendiculairement à la plaquette à circuits imprimés (3) et au composant (13), caractérisée par le fait que la colonne d'observation possède au moins une fenêtre d'observation (21;22) en un matériau transparent et permettant d'observer le brasage.

2. Tête de brasage (1) suivant la revendication 1, caractérisée par le fait que la colonne d'observation constitue est simultanément une colonne de circulation de gaz chaud.

3. Tête de brasage (1) suivant l'une des revendications précédentes, caractérisée par le fait que le matériau de la tête de brasage (1) est essentiellement de l'acier spécial.

4. Tête de brasage (1) suivant l'une des revendications précédentes, caractérisée par le fait que les faces intérieures d'une colonne d'observation ont un revêtement antireflet.

5. Tête de brasage (1) suivant l'une des revendications précédentes, caractérisée par le fait que la fenêtre d'observation (21,22) est en un matériau transparent et résistant à la chaleur.

6. Tête de brasage (1) suivant la revendication 5, caractérisée par le fait que le matériau résistant à la chaleur est du verre au quartz.

7. Tête de brasage (1) suivant la revendication 5 ou 6, caractérisée par le fait que la fenêtre d'observation est fermée de façon étanche par du silicone.

8. Tête de brasage (1) suivant l'une des revendications précédentes, caractérisée par le fait que la tête de brasage (1) est mobile librement, dans les trois directions de coordonnées, par rapport à la plaquette à circuits imprimés (3) et au composant (13).

9. Installation à têtes de brasage (1) selon l'une des revendications 1 à 8, caractérisée par le fait que plusieurs têtes de brasage (1) sont montées sur un plateau rotatif oblique (2) de telle sorte que respectivement l'une d'elles est verticale dans sa position de travail et peut être bloquée.
